**Europäisches Patentamt**

**European Patent Office**

**Office européen des brevets**

(19)

(11) Publication number: **0 013 117**

**B1**

(12) **EUROPEAN PATENT SPECIFICATION**

(45) Date of publication of patent specification: **24.10.84**

(21) Application number: **79302939.8**

(22) Date of filing: **18.12.79**

(51) Int. Cl.³: **H 03 K 19/094,** H 01 L 27/08, H 01 L 21/265

(54) A MOS dynamic logic circuit.

(30) Priority: **26.12.78 JP 163120/78**

(43) Date of publication of application:
**09.07.80 Bulletin 80/14**

(45) Publication of the grant of the patent:
**24.10.84 Bulletin 84/43**

(84) Designated Contracting States:
**DE FR GB**

(56) References cited:
**US-A-3 731 161**
**US-A-3 832 574**
**US-A-3 898 479**

**PATENT ABSTRACTS OF JAPAN, vol. 1, no. 142, November 15, 1977, page 6994 E 77 IEEE JOURNAL OF SOLID STATE CIRCUITS, vol. SC-13, no. 5, October 1978, New York, USA, R. OHGISHI et al. "Molybdenum gate MOS applied to an AM/FM digital frequency synthesizer", pages 555-560**

(73) Proprietor: **FUJITSU LIMITED**
**1015, Kamikodanaka Nakahara-ku**
**Kawasaki-shi Kanagawa 211 (JP)**

(72) Inventor: **Baba, Fumio**
**3-12-204, Sakonyama, Asahi-Ku**
**Yokohama-Shi, Kanagawa 241 (JP)**
Inventor: **Nakano, Tomio**
**7-9, Miyazaki 2-Chome, Takatsu-Ku**
**Kawasaki-Shi, Kanagawa 213 (JP)**
Inventor: **Enomoto, Seiji**
**3-2, Susukino 3-Chome, Midori-ku**
**Yokohama-Shi, Kanagawa 227 (JP)**

(74) Representative: **Massey, Alexander et al**
**MARKS & CLERK Scottish Life House Bridge Street**
**Manchester, M3 3DP (GB)**

Courier Press, Leamington Spa, England.

## Description

The present invention relates to a MOS dynamic logic circuit. A MOS dynamic logic circuit in accordance with the present invention is applicable to circuits, such as a dynamic inverter circuit and a dynamic buffer circuit in electronic computers and the like.

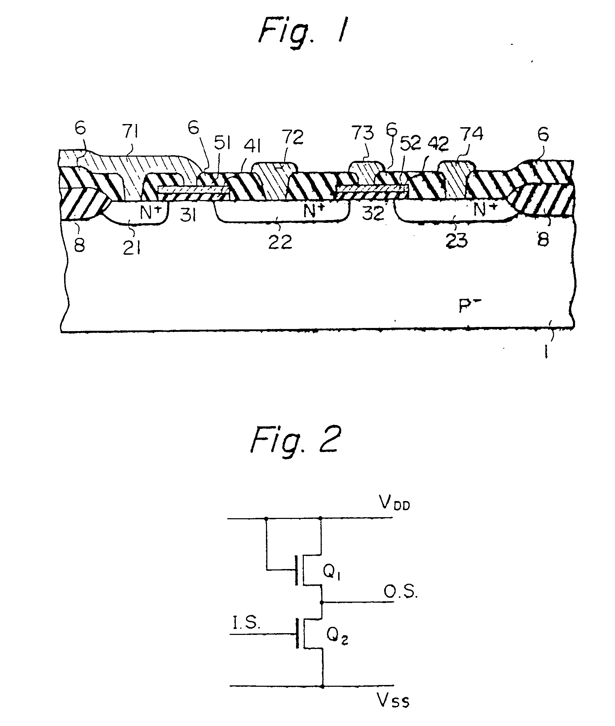

Referring to Fig. 1 there is shown a conventional MOS integrated circuit used for a static inverter, the circuit diagram of which is illustrated in Fig. 2.

The MOS integrated circuit of Fig. 1 comprises a silicon substrate 1, $N^+$ layers 21, 22, 23 formed in the upper portion of the silicon substrate 1, silicon dioxide layers 41, 42 formed on the surface of the $P^-$ type silicon substrate 1 corresponding to the channel region 31 between the $N^+$ layers 21 and 22 and the channel region 32 between the $N^+$ layers 22 and 23, gate electrodes of polycrystalline silicon 51, 52 formed on the silicon dioxide layers 41, 42, isolation coatings 6, a conductor 71 attached to the $N^+$ layer 21 and the gate electrode 51, a conductor 72 connected to the $N^+$ layer 22, a conductor 73 connected to the gate electrode 52, a conductor 74 connected to the $N^+$ layer 23 and field silicon-dioxide layers 8. The $N^+$ layer 21, the silicon dioxide layer 41, the gate electrode 51 and the $N^+$ layer 22 constitute a load side FET $Q_1$, while the $N^+$ layer 22, the silicon dioxide layer 42, the gate electrode 52 and the $N^+$ layer 23 constitute a driver side FET $Q_2$. The driver side FET $Q_2$ and the load side FET $Q_1$ constitute a static inverter of Fig. 2.

The threshold voltages of the FETs shown in Figs. 1 and 2 are determined by the impurity concentration of the silicon substrate 1 and the thickness of silicon dioxide layers 41, 42. In the MOS integrated circuit of Figs. 1 and 2 the threshold voltage Vth ($Q_2$) of the driver side FET $Q_2$ and the threshold voltage Vth ($Q_1$) of the load side FET $Q_1$ are of the same value of approximately 0.5 to 2.0 volts. As a result of these relatively high values for the threshold voltages Vth ($Q_1$) and Vth ($Q_2$), the operating speed of the static inverter is low, the level of the output voltage is low and accordingly the noise-margin of the static inverter is small. Given this, the operating characteristics of the circuit of Figs. 1 and 2 used for logic circuits such as inverters is unsatisfactory.

It is known from U.S. Patent Nos. 3 731 161 and 3 832 574 to overcome the problems associated with static logic circuits, such as the static converter of Figs. 1 and 2 described hereinabove, by providing an MOS integrated circuit in which the FET's thereof have different threshold voltages. In this respect, both of the above-mentioned documents disclose circuits in which two FET's having different threshold voltages are coupled to the same node, which is the logic output node, such that the FET with the lower threshold voltage always turns ON prior to the FET with the higher threshold. The result of this is a faster switching speed and a better noise characteristic.

However, despite this static logic circuits suffer from high power dissipation. In order to overcome this problem it is known to use a dyanamic logic circuit instead. In a dynamic iogic circuit, instead of V(DD), a clock signal I.S.-bar (not shown) which has approximately the reverse phase of that of the input signal I.S. is applied to the gate of FET Q(1). When the potential of the signal I.S.-bar goes high, while the potential of the input signal I.S. is low, the capacitances, such as the gate capacitance of the next stage or stray capacitances, which exist in the output signal line (O.S.) are charged to make the potential of the output signal line high. After that, when the potential of the signal I.S.-bar goes low, the potential of the output line, which is in a floating state is maintained high. Then, when the potential of the input signal I.S. goes high, the charge stored in the capacitance is discharged via FET Q(2), and the potential of the output signal line becomes low. In this case, the power dissipation in the device can be low, because no constant direct current, as is the case in the static logic circuit flows through the device. However, since the potential of the output signal line is in a floating state while both the potentials of the signals I.S.-bar and I.S. are low, the threshold voltage of FET Q(2) cannot be selected to be low. This is because a slight leakage current flows through the field effect transistor even where the gate voltage of the field effect transistor is less than the threshold voltage V(th), the potential of the output signal is lowered because of the leakage current, and, hence, the potential of the output signal cannot be maintained high. Accordingly, FET Q(2) is required to have a threshold voltage of approximately 0.5V to 2.0V. Such a dynamic logic circuit is disclosed in U.S. Patent No. 389 479.

However, recently, short channel transistors have been widely used in order to increase the degree of integration of integrated circuit devices. In these short channel transistors, the source voltage is required to be maintained lower than a predetermined level for preventing the punch-through pnenomena and the breakdown phenomena. Under these circumstances, if the threshold voltage of the load side FET $Q_1$ and the threshold voltage of the driver side FET $Q_2$ are the same, both the level of the output signal and the speed of the operation are reduced. Such reductions of the level of the output signal and the speed of the operation represent quite serious problems.

It is an object of the present invention to provide a MOS dynamic circuit which can perform the desired dynamic operation without a reduction in the operational speed and in the noise-margin, even when the size of the circuit element is minimized and the source voltage is selected to be low.

According to the present invention, there is provided a MOS dynamic logic circuit, comprising a capacitive portion (C) arranged to store in a floating state, electrical charge to be utilised in the operation of the circuit, a first enhancement type FET (Q11) for controlling charging of the capacitive portion, a second enhancement type FET (Q25) for controlling discharging of the capacitive portion, a third enhancement type FET (Q12) for load side charging-up and a fourth enhancement type FET (Q26) for load side discharging, the connecting point of the third FET (Q12) and the fourth FET (Q26) forming an output node, the capacitive portion being connected between the connecting point of the first and second FET and the output node, the gates of the first FET (Q11) and the second FET (Q25) receiving input signals of opposite phase, the gate of the third FET being connected to the connecting point of the first and second FET, and the gate of the fourth FET (Q26) receiving an input signal which is delayed from the signal supplied to the gate of the second FET (Q25), characterised in that the impurity concentration of a substrate (11) on which the logic circuit is fabricated is low, the threshold voltage of the first FET (Q11) and the third FET (Q12) being relatively low and the threshold voltage of the second FET (Q25) and the fourth FET (Q26) being made relatively high by introducing local impurities into the substrate.

In the drawings:

Fig. 1 illustrates a conventional MOS integrated circuit for use as a static inverter;

Fig. 2 illustrates the circuit diagram of the MOS integrated circuit device of Fig. 1;

Fig. 3 illustrates the circuit diagram of a dynamic circuit consisting of a MOS integrated circuit in accordance with the present invention; and

Fig. 4 illustrates the structure of the MOS integrated circuit device of the dynamic circuit of Fig. 3.

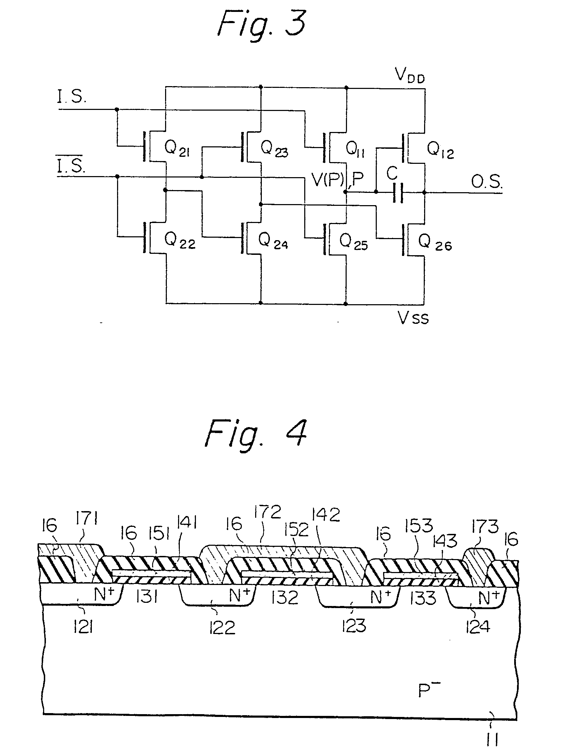

An MOS integrated circuit dynamic inverter in accordance with the present invention will now be described for the dynamic circuit illustrated in Fig. 3. Series connected FETs $Q_{21}$, $Q_{22}$; $Q_{23}$, $Q_{24}$; $Q_{11}$, $Q_{25}$ and $Q_{12}$, $Q_{26}$ are in parallel and connected between $V_{DD}$ and $V_{SS}$. The connecting point of FETs $Q_{21}$ and $Q_{22}$ is connected to the gate of FET $Q_{24}$. The connecting point of FETs $Q_{23}$ and $Q_{24}$ is connected to the gate of FET $Q_{26}$. The connecting point of the FETs $Q_{11}$ and $Q_{25}$ is connected to the gate of the FET $Q_{12}$ and an electrode of the condenser C formed by the MOS capitance. The gates of the FETs $Q_{21}$ and $Q_{11}$ receive the input signal I.S. and the gates of the FETs $Q_{22}$, $Q_{23}$ and $Q_{25}$ receive the inverted input signal I.S.-bar. The output signal U.S. is obtained at the connecting point of the FETS $Q_{12}$ and $Q_{26}$. The FETs $Q_{11}$ and $Q_{12}$ and the condenser C correspond to the load side FET $Q_1$ of Fig. 2, while the FETs $Q_{25}$ and $Q_{26}$ correspond to the driver side FET $Q_2$ of Fig. 2.

Under the condition where the potential of the input signal I.S. is low and the potential of the signal I.S.-bar is high, the FETs Q(21) and Q(11) are off and the FETs Q(22), Q(23), and Q(25) are on, hence the FETs Q(24) and Q(12) are off and the FET Q(26) is on. Accordingly, the potential of the output line O.S. is low. When the potential of the input signal I.S. turns high upon receipt of a clock signal and hence the potential of the signal I.S.-bar turns low, the FETs Q(21) and Q(11) become on and FETs Q(22), Q(23) and Q(25) become off, hence FETs Q(24) and Q(12) become on. Accordingly, the potential of the output line O.S. becomes high. When FET Q(11) turns on, the capacitance C is charged via a path of Q(11), C and Q(26). In this regard, Q(26) still maintains the ON state for a predetermined period after Q(11) turns on, after which Q(26) turns off. Thus, Q(26) begins to turn off and the potential of the output line begins to rise while Q(12) is in the on state, hence the capacitor C pushes up the potential of the node P and accordingly the potential of the gate of Q(12) to place Q(12) completely at the ON state.

In the circuit of Fig. 3 according to the present invention, the threshold voltage of Q(11) is selected low, while the threshold voltage of Q(25) is selected high. Due to such selection of the threshold voltages, when the potential of the signal I.S. turns to high and hence Q(11) turns on and the capacitor C is charged, the potential V(P) of the node P is raised up to approximately equal to V(DD) and hence the capacitor C is charged sufficiently. Thus, the potential of the gate of Q(12) is pushed up and accordingly the dynamic operation of the device is carried out satisfactorily. While, since the threshold voltage of Q(25) is high, when the potential of the signal I.S.-bar is low, Q(25) completely becomes at the OFF state without passing leakage current, hence the potential V(P) of the node P completely becomes at floating state. Accordingly the potential V(P) is maintained sufficiently high.

The structure of a portion, consisting of the FETs $Q_{12}$ and $Q_{26}$ and the condenser C, of the MOS dynamic circuit of Fig. 3 is illustrated in Fig. 4. In Fig. 4, a $P^-$ type silicon 11, $N^+$ layers 121, 122, 123, 124 formed in the upper portion of the silicon substrate 11, silicon dioxide layers 141, 142 and 143 formed on the surface of the silicon substrate 11 corresponding to the channel regions 131, 132 and 133, respectively, gate electrodes of polycrystalline silicon 151, 152 and 153 formed on the silicon dioxide layers 141, 142 and 143, respectively, isolation coatings 16, a conductor 171 connected to the $N^+$ layer 121, a conductor 172 connected to the $N^+$ layers 122 and 123 and a conductor 173 connected to the $N^+$ layer 124 are illustrated.

The $N^+$ layer 121, the channel region 131 and the $N^+$ layer 122 constitute the FET $Q_{12}$. The $N^+$ layer 122, the channel region 132 and the $N^+$ layer 123 constitute the condenser C. The $N^+$ layer 123, the channel region 133 and $N^+$ layer 124 constitute the FET $Q_{26}$. In accord-

ance with the present invention, the impurity concentration of the channel region 133 under the silicon dioxide layer 143 which forms a portion of the FET $Q_{26}$ is increased.

Due to the structure of Fig. 4, the voltage V(P) at the point P in the circuit of Fig. 3 rises quickly upon application of an input signal I.S. and subsequently is pushed up to a high level by the effect of the condenser C. Accordingly, the MOS dynamic circuit of Figs. 3 and 4 provides high operation speed, high output voltage level and accordingly a sufficient Noise-margin.

It will be appreciated that in the MOS integrated circuit used for a dynamic inverter in accordance with the present invention, the impurity concentration of the silicon substrate 1 is selected to be low, and the local impurity concentration of a region of the silicon substrate, where relatively high threshold voltage is needed, is changed by a process such as ion implantation or low concentration diffusion. Although both the ion implantation process and the diffusion process are available to change the local impurity concentration of the silicon substrate, the ion implantation process is more appropriate than the diffusion process because precise control in the diffusion process is difficult.

In a dynamic inverter embodying the present invention the threshold voltage of the load side FET is approximately 0 to 0.5 Volts and the threshold voltage of the driver side FET is approximately 0.5 to 2.0 Volts. The selected low impurity concentration ($N_B$) of the silicon substrate 1 is approximately $1 \times 10^{15}$ cm$^{-3}$ to $7 \times 10^{15}$ cm$^{-3}$.

## Claims

1. A MOS dynamic logic circuit, comprising a capacitive portion (C) arranged to store in a floating state electrical charge to be utilised in the operation of the circuit, a first enhancement type FET (Q11) for controlling charging of the capacitive portion, a second enhancement type FET (Q25) for controlling discharging of the capacitive portion, a third enhancement type FET (Q12) for load side charging-up and a fourth enhancement type FET (Q26) for load side discharging, the connected point of the third FET (Q12) and the fourth FET (Q26) forming an output node, the capacitive portion being connected between the connecting point of the first and second FET and the output node, the gates of the first FET (Q11) and the second FET (Q25) receiving input signals of opposite phase, the gate of the third FET being connected to the connecting point of the first and second FET, and the gate of the fourth FET (Q26) receiving an input signal which is delayed from the signal supplied to the gate of the second FET (Q25), characterised in that the impurity concentration of a substrate (11) on which the logic circuit is fabricated is low, the threshold voltage of the first FET (Q11) and the third FET (Q12) being relatively low and the threshold of the second FET (Q25) and the fourth FET (Q26) being made relatively high by introducing local impurities into the substrate.

2. A MOS dynamic logic circuit according to claim 1, in which the local impurity concentration of the substrate is increased by ion implantation.

## Revendications

1. Circuit logique dynamique MOS, comprenant une partie capacitive (C) destinée à emmagasiner dans un état flottant une charge électrique à utiliser dans le fonctionnement du circuit, un premier TEC de type enrichissement (Q11) servant à commander la charge de la partie capacitive, un deuxième TEC du type enrichissement (Q25) servant à commander la décharge de la partie capacitive, un troisième TEC du type enrichissement (Q12) servant à la charge du côté charge, c'est-à-dire utilisation, et un quatrième TEC du type enrichissement (Q26) servant à la décharge côté charge, ou utilisation, le point de connexion du troisième TEC (Q12) et du quatrième TEC (Q26) formant un noeud de sortie, la partie capacitive étant connectée entre le point de connexion des premier et deuxième TEC et une sortie, les grilles du premier TEC (Q11) et du deuxième TEC (Q25) recevant des signaux d'entrée de phases opposées, la grille du troisième TEC étant connectée au point de connexion des premier et deuxième TEC, et la grille du quatrième TEC (Q26) recevant un signal d'entrée qui est retardé par rapport au signal fourni à la grille du deuxième TEC (Q25), caractérisé en ce que la concentration en impureté d'un substrat (11) sur lequel le circuit logique est fabriqué est basse, les tensions de seuil du premier TEC (Q11) et du troisième TEC (Q12) étant relativement basseset les tensions de seuil du deuxième TEC (Q25) et du quatrième TEC (Q26) étant rendues relativement élevées par introduction d'impuretés locales dans le substrat.

2. Circuit logique dynamique MOS selon la revendication 1, dans lequel la concentration en impuretés locales du substrat est accrue par implantation ionique.

## Patentansprüche

1. Dynamische logische MOS-Schaltung mit einem kapazitiven Abschnitt (C), der so angeordnet ist, daß er in einem schwebenden Zustand eine beim Betrieb der Schaltung zu verwendende elektrische Ladung speichert, einem ersten FET (Q11) vom Anreicherungstyp zur Steuerung der Ladung des kapazitiven Abschnitts, einem zweiten FET (Q25) vom Anreicherungstyp zur Steuerung der Entladung des kapazitiven Abschnitts, einem dritten FET (Q12) vom Anreicherungstyp zur Lastseitenaufladung und einem vierten Anreicherungs-FET (Q26) zur Lastseitenentladung, wobei der Verbindungspunkt des dritten FET (Q12) und des vierten FET (Q26) einen Ausgangsknoten bilden, der kapazitive Abschnitt zwischen dem Verbindungspunkt des ersten und zweiten FET und dem Ausgangsknotenpunkt angeschlossen ist, die Gateelektroden des erste FET (Q11) und des zweiten FET (Q25) Eingangssignale entgegengesetzter Phase empfangen, die Gateelektrode des dritten FET mit dem Verbindungspunkt des ersten und des zweiten FET verbunden ist und die Gateelektrode des vierten FET (Q26) ein Eingangssignal empfängt, das gegenüber dem der Gateelektrode des zweiten FET (Q25) zugeführten Signal verzögert ist, dadurch gekennzeichnet, daß die Verunreinigungskonzentration des Substrats (11), auf welchem die logische Schaltung hergestellt ist, niedrig ist, die Schwellenwertspannungen des ersten FET (Q11) und des dritten FET (Q12) relativ niedrig sind und die Schwellenwerte des zweiten FET (Q25) und des vierten FET (Q26) durch Einführung lokaler Verunreinigungen in das Substrat relativ hoch gemacht sind.

2. Dynamische logische MOS-Schaltung nach Anspruch 1, bei welcher die lokale Verunreinigungskonzentration des Substrats durch Ionenimplantation erhöht ist.

## Fig. 1

## Fig. 2

# Fig. 3

# Fig. 4